# EUROPÄISCHE PATENTSCHRIFT

(11) **EP 1 601 630 B1**
(45) Veröffentlichungstag und Bekanntmachung des Hinweises auf die Patenterteilung: **27.12.2017**
(21) Anmeldenummer: 04703308.9
(22) Anmeldetag: 20.01.2004
(51) Int. Cl.: C04B 35/528, C22C 26/00, C22C 21/02, C04B 35/634, C04B 35/653, C22C 1/10, H01L 23/373

(54) **WÄRMESENKE MIT HOHER WÄRMELEITFÄHIGKEIT**
HEAT SINK HAVING A HIGH THERMAL CONDUCTIVITY
DISSIPATEUR THERMIQUE A HAUTE CONDUCTIVITE THERMIQUE

(30) Priorität: 11.03.2003 AT 16403 U
(43) Veröffentlichungstag der Anmeldung: 07.12.2005
(73) Patentinhaber: PLANSEE SE, 6600 Reutte (AT)
(72) Erfinder: LÜDTKE, Arndt, A-6600 Reutte (AT)
(86) Internationale Anmeldenummer: PCT/AT2004/000018
(87) Internationale Veröffentlichungsnummer: WO 2004/080914

(56) Entgegenhaltungen:
- EP-A- 0 475 575
- EP-A- 0 691 413
- WO-A2-02/42240
- US-A- 4 735 655
- US-A- 6 039 641
- US-B1- 6 179 886

## Beschreibung

Die Erfindung betrifft ein Bauteil als Wärmesenke aus einem Verbundwerkstoff mit einem Diamantanteil von 40 - 90 Vol.%, bei einer mittleren Größe der Diamantkörner von 5 bis 300 µm und Verfahren zu dessen Herstellung.

Eine breite Anwendung finden Wärmesenken bei der Herstellung von elektronischen Komponenten. Neben der Wärmesenke sind die Halbleiterkomponente und eine mechanisch stabile Umhüllung die wesentlichen Bestandteile eines elektronischen Package. Für die Wärmesenke werden auch des öfteren die Bezeichnungen Substrat, Wärmespreizer oder Trägerplatte verwendet. Die Halbleiterkomponente besteht beispielsweise aus einkristallinem Silizium oder Galliumarsenid. Diese ist mit der Wärmesenke verbunden, wobei als Fügetechnik üblicherweise Lötverfahren zum Einsatz kommen. Die Wärmesenke hat die Funktion, die beim Betrieb der Halbleiterkomponente entstehende Wärme abzuleiten. Halbleiterkomponenten mit besonders hoher Wärmeentwicklung sind beispielsweise LDMOS (laterally diffused metal oxide semi-conductor), Laserdioden, CPU (central processing unit), MPU (microprocessor unit) oder HFAD (high frequency amplify device).
Die geometrischen Ausführungen der Wärmesenke sind anwendungsspezifisch und vielfältig. Einfache Formen sind flache Plättchen. Es werden jedoch auch komplex gestaltete Substrate mit Ausnehmungen und Stufen eingesetzt. Die Wärmesenke selbst wiederum ist mit einer mechanisch stabilen Umhüllung verbunden.
Die Wärmeausdehnungskoeffizienten der zum Einsatz kommenden Halbleiterwerkstoffe sind im Vergleich zu anderen Werkstoffen niedrig und werden in der Literatur für Silizium mit 2,1 x 10⁻⁶ K⁻¹ bis 4,1 x 10⁻⁶ K⁻¹ und für Galliumarsenid mit 5, 6 x 10⁻⁶ K⁻¹ bis 5,8 x 10⁻⁶ K⁻¹ angegeben.
Auch andere Halbleiterwerkstoffe, die großtechnisch noch nicht breit eingesetzt werden, wie z.B. Ge, In, Ga, As, P oder Siliziumkarbid weisen ähnlich niedere Ausdehnungskoeffizienten auf. Für die Umhüllung werden üblicherweise keramische Werkstoffe, Werkstoffverbunde oder auch Kunststoffe eingesetzt. Beispiele für keramische Werkstoffe sind Al₂O₃ mit einem Ausdehnungskoeffizienten von 6,5 x 10⁻⁶ K⁻¹ oder Aluminiumnitrid mit einem Ausdehnungskoeffizienten von 4,5 x 10⁻⁶ K⁻¹.

Ist das Ausdehnungsverhalten der beteiligten Komponenten unterschiedlich, werden Spannungen im Verbund eingebaut, die zu Verwerfungen, zu Ablösungen oder zum Bruch der Komponenten führen können. Spannungen können dabei bereits bei der Herstellung des Package entstehen und zwar während der Abkühlphase von der Löttemperatur auf Raumtemperatur. Jedoch auch beim Betrieb des Package treten Temperaturschwankungen auf, die beispielsweise von -50°C bis 200°C reichen und zu thermomechanischen Spannungen im Package führen können.
Daraus ergeben sich die Anforderungen an den Werkstoff für die Wärmesenke. Zum einen soll er eine möglichst hohe Wärmeleitfähigkeit aufweisen, um den Temperaturanstieg der Halbleiterkomponente während des Betriebes möglichst gering zu halten. Zum anderen ist es erforderlich, dass der Wärmeausdehnungskoeffizient möglichst gut sowohl an den der Halbleiterkomponente, als auch an den der Hülle angepasst ist. Einphasige metallische Werkstoffe erfüllen das geforderte Eigenschaftsprofil nicht ausreichend, da die Werkstoffe mit hoher Wärmeleitfähigkeit auch einen hohen Wärmeausdehnungskoeffizienten besitzen.
Daher werden, um dem Anforderungsprofil gerecht zu werden, für die Herstellung des Substrates Verbundwerkstoffe oder Werkstoffverbunde eingesetzt.
Übliche Wolfram-Kupfer und Mo-Kupfer Verbundwerkstoffe oder Werkstoffverbunde wie diese beispielsweise in der EP 0 100 232, US 4 950 554 und der US 5 493 153 beschrieben sind, weisen eine thermische Leitfähigkeit bei Raumtemperatur von 170 bis 250 W/(m.K) bei einem Wärmeausdehnungskoeffizienten von 6,5 x 10⁻⁶ bis 9,0 x 10⁻⁶ K⁻¹ auf, was für viele Anwendungen nicht mehr ausreichend ist.

Mit den steigenden Anforderungen an die thermische Leitfähigkeit von Wärmesenken fanden auch Diamant bzw. diamanthaltige Verbundwerkstoffe oder Werkstoffverbunde Interesse. So liegt die Wärmeleitfähigkeit von Diamant bei 1.000 bis 2.000 W/(m.K), wobei speziell der Gehalt an Stickstoff- und Boratomen auf Gitterplätzen qualitätsbestimmend ist.

In der EP 0 521 405 ist eine Wärmesenke beschrieben, die auf der dem Halbleiterchip zugewandten Seite eine polykristalline Diamantschicht aufweist. Durch das Fehlen einer plastischen Verformbarkeit der Diamantschicht kann es bereits beim Abkühlen von der Beschichtungstemperatur zu Rissen in der Diamantschicht kommen.

Die US 5 273 790 beschreibt einen Diamantverbundwerkstoff mit einer thermischen Leitfähigkeit > 1.700 W/(m.K), bei dem lose, in Form gebrachte Diamantteilchen mittels nachfolgender Diamantabscheidung aus der Gasphase in einen stabilen Formkörper übergeführt werden. Der so gefertigte Diamantverbund ist für die kommerzielle Anwendung in Massenteilen zu teuer.

In der WO 99/12866 ist ein Verfahren zur Herstellung eines Diamant-Siliziumkarbid-Verbundwerkstoffes beschrieben. Die Herstellung erfolgt durch Infiltration eines Diamantskelettes mit Silizium oder einer Siliziumlegierung. Aufgrund des hohen Schmelzpunktes von Silizium und der dadurch bedingten hohen Infiltrationstemperatur wird Diamant teilweise in Kohlenstoff bzw. in weiterer Folge in Siliziumkarbid umgewandelt. Auf Grund der hohen Sprödigkeit ist die mechanische Bearbeitbarkeit dieses Werkstoffes höchst problematisch und aufwendig, so dass dieser Verbundwerkstoff bisher noch nicht für Wärmesenken zum Einsatz kommt.

Die US 4 902 652 beschreibt ein Verfahren zur Herstellung eines gesinterten Diamantwerkstoffes. Auf Diamantpulver wird dabei mittels physikalischer Beschichtungsverfahren ein Element aus der Gruppe Übergangsmetalle der Gruppen 4a, 5a und 6a, Bor und Silizium abgeschieden. Anschließend werden die beschichteten Diamantkörner mittels eines Festphasensinterprozesses miteinander verbunden. Nachteilig ist, dass das entstehende Produkt eine hohe Porosität und einen für viele Anwendungen zu niedrigen Wärmeausdehnungskoeffizienten aufweist.

Die US 5 045 972 beschreibt einen Verbundwerkstoff, in dem neben Diamantkörnern mit einer Größe von 1 bis 50 µm eine metallische Matrix vorliegt, die aus Aluminium, Magnesium, Kupfer, Silber oder deren Legierungen besteht. Nachteilig dabei ist, dass die metallische Matrix nur mangelhaft an den Diamantkörnern angebunden ist, so dass dadurch die Wärmeleitfähigkeit und mechanische Integrität in nicht ausreichendem Maße gegeben ist.
Auch die Verwendung von feinerem Diamantpulver, beispielsweise mit einer Korngröße < 3 µm, wie dies aus der US 5 008 737 hervorgeht, verbessert die Diamant / Metall Haftung nicht.
Die US 5 783 316 beschreibt ein Verfahren, bei dem Diamantkörner mit W, Zr, Re, Cr oder Titan beschichtet, die beschichteten Körner in weiter Folge kompaktiert werden und der poröse Körper z.B. mit Cu, Ag oder Cu-Ag Schmelzen infiltriert wird. Die hohen Beschichtungskosten begrenzen das Einsatzgebiet derartig hergestellter Verbundwerkstoffe.
Die EP 0 859 408 beschreibt einen Werkstoff für Wärmesenken, dessen Matrix aus Diamantkörnern und Metallkarbiden gebildet ist, wobei die Zwischenräume der Matrix durch ein Metall gefüllt sind. Als Metallkarbide werden die Karbide der Metalle der 4a bis 6a Gruppen des Periodensystems bezeichnet. Besonders hervorgehoben werden dabei in der EP 0 859 408 TiC, ZrC und HfC. Als besonders vorteilhafte Füllmetalle sind Ag, Cu, Au und AI angeführt. Nachteilig ist, dass die Metallkarbide eine niedrige Wärmeleitfähigkeit aufweisen, die für TiC, ZrC, HfC, VC, NbC und TaC im Bereich von 10 bis 65 W/(m.K) liegt. Weiters ist nachteilig, dass die Metalle der 4a bis 6a Gruppen des Periodensystems eine Löslichkeit im Füllmetall, wie beispielsweise Silber aufweisen, wodurch die Wärmeleitfähigkeit der Metallphase stark reduziert wird.

EP 0 475 575 zeigt ein Bauteil, das als Wärmesenke benutzt wird. Das Bauteil ist ein Verbundwerkstoff, der 40 Vol.-% Diamant und 60 Vol.-% Al enthält. Die Diamantkörner haben eine Größe von 20 Mikron.

WO 02/42240 zeigt ein Bauteil, das als Wärmesenke benutzt wird. Dieses Bauteil enthält 3 Phasen, Diamant, SiC und Si oder Si-Legierungen. Die Diamantkörner werden völlig von der SiC-Phase umhüllt. Die mittlere Korngrösse der Diamantkörner ist 287 Mikron. Die Si-Phase kann Ag oder Al enthalten.

Die EP 0 898 310 beschreibt eine Wärmesenke, die aus Diamantkörnern, einem Metall oder einer Metalllegierung hoher Wärmeleitfähigkeit aus der Gruppe Cu, Ag, Au, Al, Mg und Zn und einem Metallkarbid der Metalle der Gruppen 4a, 5a und Cr besteht, wobei die Metallkarbide zu zumindest 25 % die Oberfläche der Diamantkörner bedecken. Auch hier wirken sich die schlechte Wärmeleitfähigkeit der Karbide der 4a, 5a Gruppen des Periodensystems und Cr und die hohe Löslichkeit dieser Elemente in Cu, Ag, Au, Al, Mg und Zn und die damit verbundene Reduzierung der Wärmeleitfähigkeit nachteilig aus.
In den letzten Jahren sind die Prozessgeschwindigkeit und der Integrationsgrad der Halbleiterkomponenten stark angestiegen, was auch zu einer Zunahme der Wärmeentwicklung im Package geführt hat. Ein optimales Wärmemanagement stellt daher ein immer wesentlicheres Kriterium dar. Die Wärmeleitfähigkeit der oben beschriebenen Werkstoffe reicht für eine Vielzahl von Anwendungen nicht mehr aus, bzw. ist deren Herstellung für eine breite Verwendung zu aufwendig. Die Verfügbarkeit von verbesserten, kostengünstigen Wärmesenken stellt eine Voraussetzung für eine weitere Optimierung von Halbleiterbauelementen dar.

Aufgabe der vorliegenden Erfindung ist somit, für ein als Wärmesenke vorgesehenes Bauteil einen Verbundwerkstoff bereitzustellen, der eine hohe Wärmeleitfähigkeit und einen niedrigen Ausdehnungskoeffizienten aufweist, bei Verarbeitungseigenschaften, die eine kostengünstige Herstellung ermöglichen. Gelöst wird diese Aufgabe durch ein Bauteil gemäß Anspruch 1.

Der erfindungsgemäße Bauteil weist eine ausgezeichnete Haftfestigkeit zwischen den Diamantkörnern und der Ag-, Au- oder Al-reichen Phase durch die sich dazwischen bildende Silizium-Kohlenstoffverbindung auf. Um diese Anbindung zu erzielen, reicht bereits eine Dicke dieser Silizium-Kohlenstoffverbindung im Nanometerbereich, bzw. eine Bedeckungsgrad von > 60 Prozent aus. Unter Bedeckungsgrad ist dabei der Anteil der Diamantkörneroberfläche zu verstehen, die mit der Silizium-Kohlenstoffverbindung bedeckt ist. Entsprechend dieser Prämissen entspricht dies einem Volumengehalt der Silizium-Kohlenstoffverbindung von
> 0,005 Prozent.
Im Gegensatz zu den Metallkarbiden besitzt Siliziumkarbid eine sehr hohe Wärmeleitfähigkeit von etwa 250 W/(m.K). Da bei Raumtemperatur die Löslichkeit von Si in Ag, Au und Al sehr gering ist, wird die im reinen Zustand sehr hohe Wärmeleitfähigkeit dieser Metalle nur geringfügig verschlechtert. Legierungen von Ag, Au oder Al mit Cu oder Ni weisen ebenfalls eine ausreichend hohe Wärmeleitfähigkeit auf, die durch geringe, gelöste Si-Anteile in einem nicht unzulässig hohen Maße verschlechtert werden.

Weiters ist die mechanische Bearbeitbarkeit auf Grund der sehr duktilen Ag-, Au- oder Al-Gefügebestandteile in einem ausreichenden Maße gegeben. Für eine kostengünstige Darstellung ist es weiters vorteilhaft, dass durch die hohe Wärmeleitfähigkeit der Ag-, Au- oder Al-reichen Gefügebestandteile der Diamantgehalt reduziert werden kann. Durch Variation des Diamant-, Siliziumkarbid- und Metallphasengehaltes ist es möglich, in Hinblick auf Wärmeleitfähigkeit und Wärmedehnung maßgeschneiderte Wärmesenken für unterschiedlichste Anforderungen herzustellen.
Weitere Gefügebestanteile verschlechtern die Eigenschaften nicht in einem unzulässigen Ausmaß, solange deren Gehalt 5 Vol.% nicht übersteigt. Dabei zu nennen sind nichtgebundenes Silizium und nichtgebundener Kohlenstoff. Diese Gefügebestandteile verschlechtern zwar geringfügig die Wärmeleitfähigkeit, wirken sich jedoch günstig auf den Wärmeausdehnungskoeffizienten aus, indem sie diesen verringern. Zudem können sie teilweise herstelltechnisch nur mit relativ großem Aufwand vollständig vermieden werden.
Besonders vorteilhafte Gehalte an Siliziumkarbid und Ag-, Au- oder AI-reicher Phase liegen bei 0,1 bis 7 Vol.% bzw. bei 7 bis 30 Vol.%. Versuche haben gezeigt, dass Diamantpulver in einem breiten Korngrößenspektrum verarbeitet werden können. Neben Naturdiamanten lassen sich auch preisgünstigere synthetische Diamanten verarbeiten. Auch mit den gängigen beschichteten Diamantsorten wurden ausgezeichnete Verarbeitungsergebnisse erzielt. Daraus ergibt sich, dass auf die jeweils kostengünstigste Sorte zurückgegriffen werden kann. Für kostenunkritische Anwendungen mit extrem hohen Anforderungen an die Wärmeleitfähigkeit ist es günstig, eine Diamantfraktion mit einer mittleren Korngröße im Bereich von 50 bis 150 µm zu verwenden. Weiteres lassen sich die höchsten Wärmeleitfähigkeitswerte durch die Verwendung von Ag bei Gehalten von 20 bis 30 Vol.% erzielen.
Für den Einsatz der Bauteile als Wärmesenken für elektronische Komponenten werden diese vorteilhafterweise mit Ni, Cu, Au oder Ag oder einer Legierung dieser Metalle beschichtet und in weiterer Folge mit einem keramischen Rahmen, beispielsweise ais Al₂O₃ oder AIN verlötet.

Für die Herstellung können unterschiedlichste Verfahren eingesetzt werden. So ist es möglich mit Siliziumkarbid beschichte Diamantpulver mit Ag, Au oder Al unter Temperatur und Druck zu verdichten. Dies kann beispielsweise in Heißpressen oder heißisostatischen Pressen erfolgen. Als besonders vorteilhaft hat sich das Infiltrieren gezeigt. Dabei wird ein Precursor oder Zwischenstoff hergestellt, der neben Diamantpulver auch einen Binder enthalten kann. Besonders vorteilhaft sind dabei Binder, die unter Temperatureinwirkung zu einem hohen Anteil pyrolisieren. Vorteilhafte Bindergehalte liegen bei 1 bis 20 Gew.%. Diamantpulver und Binder werden in üblichen Mischern oder Mühlen vermengt. Danach erfolgt die Formgebung, wobei diese durch Schüttung in eine Form oder druckunterstützt, beispielsweise durch Pressen oder Metallpulverspritzguss, erfolgen kann. In weiterer Folge wird der Zwischenstoff auf eine Temperatur erhitzt, bei der der Binder zumindest teilweise pyrolisiert. Die Pyrolyse des Binders kann jedoch auch während des Aufheizens beim Infiltrationsprozess erfolgen. Der Infiltrationsprozess kann drucklos oder druckunterstützt erfolgen. Letzteres wird üblicherweise als Squezze-Casting bezeichnet. Als Infiltrationsmaterial wird vorteilhafterweise eine Folie aus einer Ag-Si-, Au-Si- oder Al-Si-Legierung mit einem Si-Gehalt < 50 Gew.% verwendet. Für die Wahl der Zusammensetzung ist zu berücksichtigen, dass die Liquidustemperatur der jeweiligen Legierung nicht höher als 1200°C, vorteilhafterweise nicht höher als 1000°C liegt, da sich ansonsten zu hohe Diamantanteile zersetzen. Besonders gut für das Infiltrieren eigenen sich Folien mit einer eutektischen Zusammensetzung.
Neben der besonders vorteilhaften Verwendung der Bauteile für die Wärmeableitung bei Halbleiterkomponenten kann der erfindungsgemäße Verbundwerkstoff auch als Wärmesenke in anderen Anwendungsbereichen wie beispielsweise im Bereich der Luft- und Raumfahrt oder Motorenbau eingesetzt werden.
Im Folgenden wird die Erfindung durch Herstellbeispiele näher erläutert.

### Beispiel 1

Naturdiamantpulver der Qualität IIA (Micron+ SND der Element Six GmbH) mit einer mittleren Kornfraktion von 40 - 80 µm wurde mit 7 Vol.% eines Binders auf Epoxydharz-Basis vermengt. Der so hergestellte Precursor oder Zwischenstoff wurde mittels Matrizenpressen bei einem Druck von 200 MPa zu einer Platte der Dimension 35 mm x 35 mm x 5 mm gepresst. Der Porenanteil der Platte betrug ca. 15 Vol.%.
In weiterer Folge wurde diese Platte mit einer Folie aus einer eutektischen Ag-Si-Legierung bedeckt, wobei der Si-Gehalt 11 Atom% betrug und zur Infiltration in einem Ofen unter Vakuum auf eine Temperatur von 860°C erhitzt, wobei die Haltezeit 15 Minuten betrug. Nach Abkühlen auf Raumtemperatur mit einem Haltepunkt bei 400°C für ca. 10 Minuten, wurde mittels quantitativer Metallografie die Volumengehalte der vorhandenen Phasen ermittelt.
Der Wert für Siliziumkarbid lag dabei bei ca. 2 Vol.%, wobei das Siliziumkarbid großteils die Diamantkörner gleichmäßig umhüllt. Auf Grund der geringen Schichtstärke dieser Siliziumkarbidumhüllung konnte die Modifikation der Siliziumkarbidphase nicht ermittelt werden. Neben Diamant und Siliziumkarbid besteht das Gefüge aus einer Ag-reichen Phase mit eingelagerten Si-Ausscheidungen, die sich durch die eutektische Umsetzung gebildet haben. Der Volumenanteil der Ag-reichen Phase betrug ca. 12 %, der von Si ca. 1 %. Mittels EDX konnten in der Ag-reichen Phase neben Ag keine weiteren Bestandteile nachgewiesen werden, sodass auf Grund der gegebenen Detektionsgrenze davon ausgegangen werden kann, dass der Ag-Anteil bei größer 99 Atom% liegt.
Zur Bestimmung der Wärmeleitfähigkeit und des Wärmeausdehnungskoeffizienten wurde die Platte mittels Laser und Erodieren bearbeitet. Für die Wärmeleitfähigkeit bei Raumtemperatur wurde ein mittlerer Wert von 450 W/(m.K) gemessen. Die Bestimmung des Wärmeausdehnungskoeffizienten erbrachte einen mittleren Wert von 8,5 10⁻⁶ K⁻¹.

### Beispiel 2

In einem weiteren Versuch wurde synthetisches Diamantpulver der Qualität Micron+ MDA der Element Six GmbH und einer mittleren Kornfraktion von 40 - 80 µm verarbeit. Die Verarbeitung erfolgte wie in Beispiel 1 beschrieben. Die mittlere Wärmeleitfähigkeit bei Raumtemperatur des so hergestellten Verbundwerkstoffes betrug 410 W/(m.K), der mittlere Wärmeausdehnungskoeffizient 9,0 10⁻⁶ K⁻¹.

### Beispiel 3

In einem weiteren Versuch wurde synthetisches Diamantpulver der Qualität Micron+ MDA der Element Six GmbH mit einer mittleren Kornfraktion von 40 - 80 µm verarbeit. Die Precursor-Herstellung erfolgte wie in Beispiel 1 beschrieben. Die Infiltration des gepressten Precursors mit einer eutektischen Ag-Si-Schmelze wurde in einer üblichen Squeeze-Casting Vorrichtung, deren Form aus Warmarbeitsstahl auf 150°C vorgeheizt wurde, bei einem Gasdruck von ca. 40 MPa durchgeführt. Die Temperatur der Ag-Si-Schmelze betrug ca. 880°C. Die folgende, langsame Abkühlung bis Raumtemperatur wurde mit einem Haltepunkt bei 400°C für ca. 15 Minuten durchgeführt. Die mittlere Wärmeleitfähigkeit bei Raumtemperatur des so hergestellten Verbundwerkstoffes betrug 480 W/(m.K), der mittlere Wärmeausdehnungskoeffizient 8,5 10⁻⁶ K⁻¹.

### Beispiel 4

Synthetisches Diamantpulver der Qualität Micron+ MDA der Element Six GmbH mit einer mittleren Kornfraktion von 40 - 80 µm wurde gemäß Beispiel 3 verarbeitet, jedoch ohne dass bei der Abkühlung von der Infiltrationstemperatur eine Haltephase bei ca. 400°C für 15 Minuten durchgeführt wurde. Die mittlere Wärmeleitfähigkeit bei Raumtemperatur des so hergestellten Verbundwerkstoffes betrug 440 W/(m.K), der mittlere Wärmeausdehnungskoeffizient 8,5 10⁻⁶ K⁻¹.

## Patentansprüche

1. Bauteil als Wärmesenke, bestehend aus einem Verbundwerkstoff mit einem Diamantanteil von 40 bis 90 Vol.% mit einer mittleren Größe der Diamantkörner von 5 bis 300 µm;
**dadurch gekennzeichnet,**
**dass** der Verbundwerkstoff 0,005 bis 12 Vol.% einer Silizium-Kohlenstoff-Verbindung, 7 bis 49 Vol.% einer Ag-, Au- oder AI-reichen Phase und kleiner 5 Vol.% einer weiteren Phase enthält, wobei die Ag-, Au- oder AI-reiche Phase zumindest 95 Atomprozent des jeweiligen Elementes enthält, das Volumenverhältnis der Ag-, Au- oder AI-reichen Phase zu der Silizium-Kohlenstoff-Verbindung größer 4 ist und die Oberfläche der Diamantkörner zu zumindest 60 % mit der Silizium-Kohlenstoff-Verbindung bedeckt ist.

2. Bauteil nach Anspruch 1, **dadurch gekennzeichnet, dass** es sich bei der Silizium-Kohlenstoff-Verbindung um SiC handelt.

3. Bauteil nach Anspruch 1 oder 2, **dadurch gekennzeichnet, dass** die Ag-, Au- oder Al-reiche Phase Cu und/oder Ni enthält.

4. Bauteil nach Anspruch 3, **dadurch gekennzeichnet, dass** die Cu und/oder Ni enthaltende Ag-, Au- oder Al-reiche Phase auch Si enthält.

5. Bauteil nach einem der Ansprüche 1 bis 4, **dadurch gekennzeichnet, dass** der Verbundwerkstoff 0,1 bis 4,5 Vol.% nicht gebundenes Silizium enthält.

6. Bauteil nach einem der Ansprüche 1 bis 4, **dadurch gekennzeichnet, dass** der Verbundwerkstoff 0,1 bis 4,5 Vol.% nicht gebundenen Kohlenstoff enthält.

7. Bauteil nach einem der Ansprüche 1 bis 6, **dadurch gekennzeichnet, dass** die Silizium-Kohlenstoff-Verbindung überwiegend oder ausschließlich durch Umsetzung von Silizium mit dem Kohlenstoff des Diamants gebildet ist.

8. Bauteil nach einem der Ansprüche 1 bis 7, **dadurch gekennzeichnet, dass** die Diamantkorngröße 50 bis 150 µm beträgt.

9. Bauteil nach einem der Ansprüche 1 bis 8, **dadurch gekennzeichnet, dass** der Verbundwerkstoff 0,01 bis 12 Vol.% Siliziumkarbid und 7 bis 49 Vol.% einer Ag-, Au- oder AI-reichen Phase enthält.

10. Bauteil nach einem der Ansprüche 1 bis 9, **dadurch gekennzeichnet, dass** der Verbundwerkstoff 0,01 bis 7 Vol.% Siliziumkarbid und 7 bis 49 Vol.% Ag enthält

11. Bauteil nach einem der Ansprüche 1 bis 10, **dadurch gekennzeichnet, dass** auf diesem ein metallischer Überzug aufgebracht ist, der aus Ni, Cu, Au, Ag oder einer Legierung dieser Metalle besteht.

12. Bauteil nach einem der Ansprüche 1 bis 11, **dadurch gekennzeichnet, dass** auf diesem ein keramischer Rahmen aufgelötet ist.

13. Verfahren zur Herstellung eines Bauteils nach einem der Ansprüche 1 bis 12, **dadurch gekennzeichnet, dass** das Verfahren zumindest folgende Prozessschritte umfasst:
- Herstellen eines Zwischenstoffes, der Diamantkörner mit einer Korngröße von 5 bis 300 µm und einen Binder auf Polymer- oder Wachsbasis enthält, wobei der Binderanteil bei 1 bis 20 Gew.% liegt
- Formgebung des Zwischenstoffes durch druckloses oder druckunterstütztes Füllen einer Form
- Herstellen eines porösen Diamantkörpers durch Erhitzen des Zwischenstoffes auf 300°C bis 1.200°C unter Schutzgasatmosphäre zur zumindest teilweisen Pyrolyse des Binders, wobei dieser Prozessschritt in den Infiltrationsprozess integriert sein kann
- Infiltration des porösen Diamantkörpers durch Erhitzen desselben und einer siliziumhaltigen Ag-, Au- oder Al-Legierung, deren Si-Anteil bei < 40 Gew.% liegt, auf eine Temperatur über der Liquidustemperatur der jeweiligen siliziumhaltigen Ag-, Au- oder AI-Legierung, bevorzugt in Vakuum, wobei sich Silizium sowohl mit dem Kohlenstoff des pyrolisierten Binders, als auch mit Diamant zumindest teilweise zu Siliziumkarbid umsetzt.

14. Verfahren zur Herstellung eines Bauteils nach einem der Ansprüche 1 bis 12, **dadurch gekennzeichnet, dass** das Verfahren zumindest folgende Prozessschritte umfasst:
- Herstellen eines Zwischenstoffes, der Diamantkörner mit einer Korngröße von 5 bis 300 µm und einen Binder auf Polymer- oder Wachsbasis enthält, wobei der Binderanteil bei 1 bis 20 Gew.% liegt
- Formgebung des Zwischenstoffes durch druckloses oder druckunterstütztes Füllen einer Form
- Herstellen eines porösen Diamantkörpers durch Erhitzen des Zwischenstoffes auf 300°C bis 1.200°C unter Schutzgasatmosphäre zur zumindest teilweisen Pyrolyse des Binders, wobei dieser Prozessschritt in den Druckinfiltrationsprozess integriert sein kann
- Erhitzen einer siliziumhaltigen Ag-, Au- oder AI-Legierung, deren Si-Anteil bei < 40 Gew.% liegt, auf eine Temperatur über der Liquidustemperatur der jeweiligen siliziumhaltigen Ag-, Au- oder Al-Legierung und Druckinfiltration des porösen Diamantkörpers.

15. Verfahren nach Anspruch 13 oder 14, **dadurch gekennzeichnet, dass** zur Infiltration eine eutektische Ag-Si-Legierung zur Verwendung kommt.

16. Verwendung eines Bauteils nach einem der Ansprüche 1 bis 12 als Wärmesenke für Halbleiterkomponenten.

## Claims

1. A component as heat sink, consisting of a composite material having a diamond content of from 40 to 90% by volume and a mean size of the diamond grains of from 5 to 300 µm, **characterized in that** the composite material comprises from 0.005 to 12% by volume of a silicon-carbon compound, from 7 to 49% by volume of an Ag-, Au- or Al-rich phase and less than 5% by volume of a further phase, wherein the Ag-, Au- or Al-rich phase comprises at least 95 atom% of the respective element, wherein the volume ratio of the Ag-, Au- or Al-rich phase to the silicon-carbon compound is greater than 4 and wherein at least 60% of the surface of the diamond grains is covered by the silicon-carbon compound.

2. The component as claimed in claim 1, **characterized in that** the silicon-carbon compound is SiC.

3. The component as claimed in claim 1 or 2, **characterized in that** the Ag-, Au- or Al-rich phase further comprises Cu and/or Ni.

4. The component as claimed in claim 3, **characterized in that** the Cu and/or Ni-containing Ag-, Au- or Al-rich phase further comprises Si.

5. The component as claimed in any of claims 1 to 4, **characterized in that** the composite material contains from 0.1 to 4.5% by volume of free silicon.

6. The component as claimed in any of claims 1 to 4, **characterized in that** the composite material contains from 0.1 to 4.5% by volume of free carbon.

7. The component as claimed in any of claims 1 to 6, **characterized in that** the silicon-carbon compound is formed predominantly or exclusively by reaction of silicon with the carbon of the diamond.

8. The component as claimed in any of claims 1 to 7, **characterized in that** the diamond particle size is from 50 to 150 µm.

9. The component as claimed in any of claims 1 to 8, **characterized in that** the composite material comprises from 0.01 to 12% by volume of silicon carbide and from 7 to 49% by volume of an Ag-, Au- or Al-rich phase.

10. The component as claimed in any of claims 1 to 9, **characterized in that** the composite material comprises from 0.01 to 7% by volume of silicon carbide and from 7 to 49% by volume of Ag.

11. The component as claimed in any of claims 1 to 10, **characterized in that** a metallic coating consisting of Ni, Cu, Au, Ag or an alloy of these metals has been applied to it.

12. The component as claimed in any of claims 1 to 11, **characterized in that** a ceramic frame has been welded onto it.

13. A process for producing a component as claimed in any of claims 1 to 12, **characterized in that** the process comprises at least the following process steps:
- production of an intermediate comprising diamond grains having a particle size of from 5 to 300 µm and a binder based on polymer or wax, with the proportion of binder being from 1 to 20% by weight,
- shaping the intermediate by introduction into a mold non-pressurized or with the aid of pressure,
- production of a porous diamond body by heating the intermediate to from 300°C to 1200°C under a protective gas atmosphere to pyrolyze the binder at least partially, with this process step being able to be integrated into the infiltration process,
- infiltration of the porous diamond body by heating it and a silicon-containing Ag, Au or Al alloy whose Si content is < 40% by weight to a temperature above the liquidus temperature of the respective silicon-containing Ag, Au or Al alloy, preferably under vacuum, with at least part of the silicon reacting both with the carbon of the pyrolized binder and with diamond to form silicon carbide.

14. A process for producing a component as claimed in any of claims 1 to 12, **characterized in that** the process comprises at least the following process steps:
- production of an intermediate comprising diamond grains having a particle size of from 5 to 300 µm and a binder based on polymer or wax, with the proportion of binder being from 1 to 20% by weight,
- shaping the intermediate by introduction into a mold non-pressurized or with the aid of pressure,
- production of a porous diamond body by heating the intermediate to from 300°C to 1200°C under a protective gas atmosphere to pyrolyze the binder at least partially, with this process step being able to be integrated into the pressure infiltration process,
- heating of a silicon-containing Ag, Au or Al alloy whose Si content is < 40% by weight to a temperature above the liquidus temperature of the respective silicon-containing Ag, Au or Al alloy and pressure infiltration of the porous diamond body.

15. The process as claimed in claim 13 or 14, **characterized in that** a eutectic Ag-Si alloy is used for the infiltration.

16. The use of a component as claimed in any of claims 1 to 12 as heat sink for semiconductor components.

## Revendications

1. Pièce formant dissipateur thermique, se composant d'un matériau composite avec une part de diamant de 40 à 90 % en volume avec une taille moyenne des grains de diamant de 5 à 300 µm;
**caractérisée en ce que** le matériau composite contient 0,005 à 12 % en volume d'un composé de silicium-carbone, 7 à 49 % en volume d'une phase riche en Ag, Au ou Al et moins de 5 % en volume d'une autre phase, dans laquelle la phase riche en Ag, Au ou Al contient au moins 95 % atomiques de l'élément respectif, le rapport volumique de la phase riche en Ag, Au ou Al au composé de silicium-carbone est supérieur à 4 et la surface des grains de diamant est recouverte à raison d'au moins 60 % par le composé silicium-carbone.

2. Pièce selon la revendication 1, **caractérisée en ce que** le composé de silicium-carbone est le SiC.

3. Pièce selon la revendication 1 ou 2, **caractérisée en ce que** la phase riche en Ag, Au ou Al contient du Cu et/ou du Ni.

4. Pièce selon la revendication 3, **caractérisée en ce que** la phase riche en Ag, Au ou Al contenant du Cu et/ou du Ni contient aussi du Si.

5. Pièce selon l'une quelconque des revendications 1 à 4, **caractérisée en ce que** le matériau composite contient 0,1 à 4,5 % en volume de silicium non lié.

6. Pièce selon l'une quelconque des revendications 1 à 4, **caractérisée en ce que** le matériau composite contient 0,1 à 4,5 % en volume de carbone non lié.

7. Pièce selon l'une quelconque des revendications 1 à 6, **caractérisée en ce que** le composé de silicium-carbone est formé principalement ou exclusivement par conversion de silicium avec le carbone du diamant.

8. Pièce selon l'une quelconque des revendications 1 à 7, **caractérisée en ce que** la taille des grains de diamant vaut 50 à 150 µm.

9. Pièce selon l'une quelconque des revendications 1 à 8, **caractérisée en ce que** le matériau composite contient 0,01 à 12 % en volume de carbure de silicium et 7 à 49 % en volume d'une phase riche en Ag, Au ou Al.

10. Pièce selon l'une quelconque des revendications 1 à 9, **caractérisée en ce que** le matériau composite contient 0,01 à 7 % en volume de carbure de silicium et 7 à 49 % en volume d'Ag.

11. Pièce selon l'une quelconque des revendications 1 à 10, **caractérisée en ce qu'**un revêtement métallique est déposé sur celle-ci, lequel se compose de Ni, Cu, Au, Ag ou d'un alliage de ces métaux.

12. Pièce selon l'une quelconque des revendications 1 à 11, **caractérisée en ce qu'**un cadre céramique est brasé sur celle-ci.

13. Procédé de fabrication d'une pièce selon l'une quelconque des revendications 1 à 12, **caractérisé en ce que** le procédé comprend au moins les étapes suivantes:
- fabriquer un produit intermédiaire, qui contient des grains de diamant avec une taille de grains de 5 à 300 µm et un liant à base de polymère ou de cire, dans lequel la part de liant est de 1 à 20 % en poids,
- mettre en forme le produit intermédiaire par remplissage d'un moule sans pression ou avec pression d'appoint,
- fabriquer un corps de diamant poreux par chauffage du produit intermédiaire à 300°C à 1200°C sous une atmosphère de gaz protecteur pour la pyrolyse au moins partielle du liant, dans lequel cette étape peut être intégrée dans le processus d'infiltration,
- infiltration du corps de diamant poreux par chauffage de celui-ci et d'un alliage de Ag, Au ou Al contenant du silicium, dont la part de Si se situe à < 40 % en poids, à une température supérieure à la température de liquidus de l'alliage de Ag, Au ou Al respectif contenant du silicium, de préférence sous vide, dans lequel du silicium se convertit au moins partiellement en carbure de silicium aussi bien avec le carbone du liant pyrolysé qu'avec du diamant.

14. Procédé de fabrication d'une pièce selon l'une quelconque des revendications 1 à 12, **caractérisé en ce que** le procédé comprend les étapes suivantes:
- fabriquer un produit intermédiaire, qui contient des grains de diamant avec une taille de grains de 5 à 300 µm et un liant à base de polymère ou de cire, dans lequel la part de liant est de 1 à 20 % en poids,
- mettre en forme le produit intermédiaire par remplissage d'un moule sans pression ou avec pression d'appoint,
- fabriquer un corps de diamant poreux par chauffage du produit intermédiaire à 300°C à 1200°C sous une atmosphère de gaz protecteur pour la pyrolyse au moins partielle du liant, dans lequel cette étape peut être intégrée dans le processus d'infiltration sous pression,
- chauffer un alliage de Ag, Au ou Al contenant du silicium, dont la part de Si se situe à < 40 % en poids, à une température supérieure à la température de liquidus de l'alliage de Ag, Au ou Al respectif contenant du silicium et infiltration sous pression du corps de diamant poreux.

15. Procédé selon la revendication 13 ou 14, **caractérisé en ce que** l'on utilise pour l'infiltration un alliage eutectique Ag-Si.

16. Utilisation d'une pièce selon l'une quelconque des revendications 1 à 12 comme dissipateur de chaleur pour des composants semi-conducteurs.
